# EUROPEAN PATENT APPLICATION

(11) **EP 4 343 855 A1**
(43) Date of publication of application: **27.03.2024**
(21) Application number: 23159217.1
(22) Date of filing: 28.02.2023
(51) Int. Cl.: H01L 29/739, H01L 29/40, H01L 29/66, H01L 29/423, H01L 29/10, H01L 29/06

(54) **SEMICONDUCTOR DEVICE**

(30) Priority: 21.09.2022 JP 2022149685
(71) Applicant: Kabushiki Kaisha Toshiba, Minato-ku Tokyo (JP); Toshiba Electronic Devices & Storage Corporation, Tokyo (JP)
(72) Inventor: ITOKAZU, Hiroko, Kanagawa (JP); IWAKAJI, Yoko, Tokyo (JP); KAWAMURA, Keiko, Kanagawa (JP); MATSUDAI, Tomoko, Tokyo (JP); FUSE, Kaori, Kanagawa (JP); MOTAI, Takako, Kanagawa (JP)
(74) Representative: Kramer Barske Schmidtchen Patentanwälte PartG mbB

(57) **Abstract**

A semiconductor device (1 to 5, 8a, 8b, 9a, 9b) includes a semiconductor part (10), first to fourth electrodes (20, 30, 50, 60) and a control electrode (40). The first and second electrodes (20. 30) are provided respectively on back and front surfaces (10B, 10F) of the semiconductor part (10). The third electrode (50) is provided between the first and second electrodes (20, 30), and provided in the semiconductor part (10) with a first insulating film (21) interposed. The fourth and control electrodes (60, 40) are provided between the second and third electrodes (30, 50). The fourth and control electrodes (60, 40) extends into the semiconductor part (10) from the front side (10F) and faces the third electrode (50) with a second insulating film (23) interposed. The fourth electrode (60) is positioned between the semiconductor part (10) and the control electrode (40). The first insulating film (21) extends between the semiconductor part (10) and the control electrode (40) and between the semiconductor part (10) and the fourth electrode (60). The fourth electrode (60) faces the control electrode (40) with a third insulating film (25) interposed, and is electrically connected to the third electrode (50).

## Description

### FIELD

Embodiments relate to a semiconductor device.

### BACKGROUND

It is required for a power control semiconductor device to reduce the switching loss and increase the breakdown immunity.

### BRIEF DESCRIPTION OF THE DRAWINGS

FIG. 1 is a schematic cross-sectional view showing a semiconductor device according to an embodiment;
FIG. 2 is a schematic plan view showing the semiconductor device according to the embodiment;
FIGS. 3A and 3B are other schematic cross-sectional views showing the semiconductor device according to the embodiment;
FIGS. 4A and 4B are yet other schematic cross-sectional views showing the semiconductor device according to the embodiment;
FIG. 5 is a time chart showing operations of the semiconductor device according to the embodiment;
FIGS. 6A to 8C are schematic cross-sectional views showing manufacturing processes of the semiconductor device according to the embodiment;
FIGS. 9A and 9B are schematic cross-sectional views showing semiconductor devices according to a first modification of the embodiment;
FIG. 10 is a schematic plan view showing a semiconductor device according to a second modification of the embodiment;
FIG. 11 is a schematic cross-sectional view showing a semiconductor device according to a third modification of the embodiment;
FIGS. 12A and 12B are schematic cross-sectional views showing semiconductor devices according to a fourth modification of the embodiment;
FIGS. 13A to 14C are schematic cross-sectional views showing manufacturing processes of the semiconductor device according to the fourth modification of the embodiment; and
FIGS. 15A to 15D are schematic cross-sectional views showing semiconductor devices according to a fifth modification of the embodiment.

### DETAILED DESCRIPTION

According to one embodiment, a semiconductor device includes a semiconductor part, first to fourth electrodes and a control electrode. The first electrode is provided on a back surface of the semiconductor part; and the second electrode is provided on a front surface of the semiconductor part at a side opposite to the back surface. The third electrode is provided between the first electrode and the second electrode, and provided in the semiconductor part with a first insulating film interposed. The third electrode is electrically insulated from the semiconductor part by the first insulating film. The control electrode is provided between the second electrode and the third electrode. The control electrode extends into the semiconductor part from the front side of the semiconductor part and faces the third electrode with a second insulating film interposed. The first insulating film extends between the semiconductor part and the control electrode and electrically insulates the control electrode from the semiconductor part. The fourth electrode is provided between the second electrode and the third electrode. The fourth electrode extends into the semiconductor part from the front side of the semiconductor part and is positioned between the semiconductor part and the control electrode. The first insulating film extends between the semiconductor part and the fourth electrode; and the second insulating film extends between the third electrode and the fourth electrode. The fourth electrode faces the control electrode with a third insulating film interposed; and the fourth electrode is electrically connected to the third electrode.

Embodiments will now be described with reference to the drawings. The same portions inside the drawings are marked with the same numerals; a detailed description is omitted as appropriate; and the different portions are described. The drawings are schematic or conceptual; and the relationships between the thicknesses and widths of portions, the proportions of sizes between portions, etc., are not necessarily the same as the actual values thereof. The dimensions and/or the proportions may be illustrated differently between the drawings, even in the case where the same portion is illustrated.

There are cases where the dispositions of the components are described using the directions of XYZ axes shown in the drawings. The X-axis, the Y-axis, and the Z-axis are orthogonal to each other. Hereinbelow, the directions of the X-axis, the Y-axis, and the Z-axis are described as an X-direction, a Y-direction, and a Z-direction. Also, there are cases where the Z-direction is described as upward and the direction opposite to the Z-direction is described as downward.

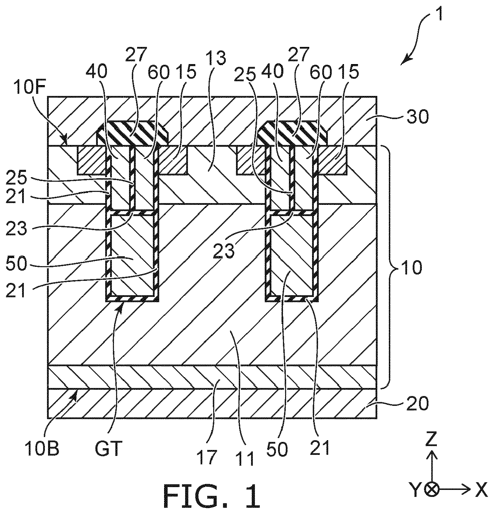

FIG. 1 is a schematic cross-sectional view showing a semiconductor device 1 according to an embodiment. The semiconductor device 1 is, for example, an IGBT (Insulated Gate Bipolar Transistor).

As shown in FIG. 1, the semiconductor device 1 includes a semiconductor part 10, a first electrode 20, a second electrode 30, a control electrode 40, a third electrode 50, and a fourth electrode 60. The semiconductor part 10 is, for example, silicon.

The semiconductor part 10 is provided between the first electrode 20 and the second electrode 30. The first electrode 20 is, for example, a collector electrode and is provided on a back surface 10B of the semiconductor part 10. The second electrode 30 is, for example, an emitter electrode and is provided on a front surface 10F of the semiconductor part 10 at the side opposite to the back surface 10B.

The control electrode 40, the third electrode 50, and the fourth electrode 60 are positioned, for example, between the first electrode 20 and the second electrode 30. The semiconductor part 10 includes, for example, a gate trench GT provided at the front surface 10F side. The control electrode 40, the third electrode 50, and the fourth electrode 60 are provided in the gate trench GT.

The control electrode 40 is, for example, a gate electrode. The control electrode 40 extends into the semiconductor part 10 from the front surface 10F side of the semiconductor part 10. The control electrode 40 is electrically insulated from the semiconductor part 10 by a first insulating film 21. The first insulating film 21 is, for example, a gate insulating film.

The third electrode 50 is provided inside the semiconductor part 10 and is electrically insulated from the semiconductor part 10 by, for example, the first insulating film 21. The first insulating film 21 extends between the semiconductor part 10 and the third electrode 50. The third electrode 50 is positioned between the first electrode 20 and the control electrode 40. The control electrode 40 is provided between the second electrode 30 and the third electrode 50. The control electrode 40 faces the third electrode 50 via a second insulating film 23. The control electrode 40 is electrically insulated from the third electrode 50 by the second insulating film 23.

The fourth electrode 60 also extends into the semiconductor part 10 from the front surface 10F side of the semiconductor part 10. The fourth electrode 60 is provided between the second electrode 30 and the third electrode 50. The second insulating film 23 extends between the third electrode 50 and the fourth electrode 60; and the fourth electrode 60 faces the third electrode 50 via the second insulating film 23.

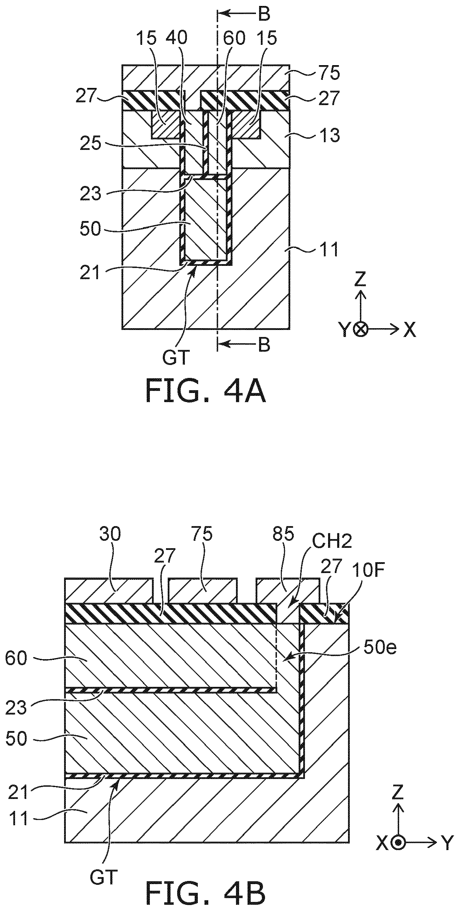

The fourth electrode 60 is positioned between the semiconductor part 10 and the control electrode 40. The first insulating film 21 extends between the semiconductor part 10 and the fourth electrode 60 and electrically insulates the fourth electrode 60 from the semiconductor part 10. The fourth electrode 60 faces the control electrode 40 via a third insulating film 25. The fourth electrode 60 is electrically insulated from the control electrode 40 by the third insulating film 25. The fourth electrode 60 is electrically connected to the third electrode 50 (see FIG. 4B).

The control electrode 40 and the fourth electrode 60 are electrically insulated from the second electrode 30 by a fourth insulating film 27. The fourth insulating film 27 is, for example, an inter-layer insulating film. The third electrode 50 and the fourth electrode 60 serve as, for example, a second control electrode.

As shown in FIG. 1, the semiconductor part 10 includes a first semiconductor layer 11 of a first conductivity type, a second semiconductor layer 13 of a second conductivity type, a third semiconductor layer 15 of the first conductivity type, and a fourth semiconductor layer 17 of the second conductivity type. Hereinbelow, the first conductivity type is described as an n-type and the second conductivity type is described as a p-type, but the embodiments are not limited thereto.

The first semiconductor layer 11 is, for example, an n-type base layer. The first semiconductor layer 11 extends between the first electrode 20 and the second electrode 30. The third electrode 50 is positioned inside the first semiconductor layer 11 and faces the first semiconductor layer 11 via the first insulating film 21.

The second semiconductor layer 13 is, for example, a p-type base layer. The second semiconductor layer 13 is provided between the first semiconductor layer 11 and the second electrode 30. The second semiconductor layer 13 faces the control electrode 40 via the first insulating film 21.

As shown in FIG. 1, the semiconductor part 10 further includes another second semiconductor layer 13; and the control electrode 40 and the fourth electrode 60 are positioned between the second semiconductor layer 13 and the other second semiconductor layer 13. The other second semiconductor layer 13 faces the fourth electrode 60 via the first insulating film 21.

The third semiconductor layer 15 is, for example, an n-type emitter layer. The third semiconductor layer 15 is provided between the second semiconductor layer 13 and the second electrode 30; and is partially provided on the second semiconductor layer 13. The third semiconductor layer 15 contacts the first insulating film 21.

The second electrode 30 covers the fourth insulating film 27 and the front surface 10F of the semiconductor part 10. The second electrode 30 is electrically connected to the second and third semiconductor layers 13 and 15 at, for example, the front surface 10F of the semiconductor part 10.

The fourth semiconductor layer 17 is, for example, a p-type collector layer. The fourth semiconductor layer 17 is provided between the first semiconductor layer 11 and the first electrode 20. The first electrode 20 is in contact with, for example, the fourth semiconductor layer 17 and electrically connected thereto.

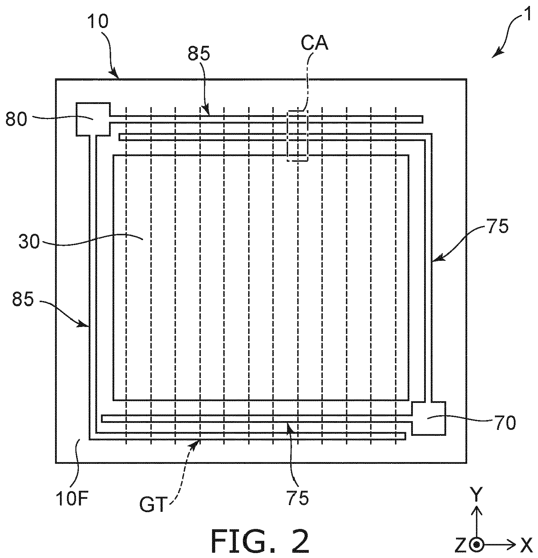

FIG. 2 is a schematic plan view showing the semiconductor device 1 according to the embodiment. FIG. 2 is a plan view showing the front surface 10F side of the semiconductor part 10.

As shown in FIG. 2, the second electrode 30, a first control pad 70, a second control pad 80, a first interconnect 75, and a second interconnect 85 are provided at the front surface 10F side of the semiconductor part 10. The first control pad 70 and the second control pad 80 are apart from each other and are apart from the second electrode 30. The first control pad 70, the second control pad 80, the first interconnect 75, and the second interconnect 85 are provided on the front surface 10F of the semiconductor part 10 with, for example, the fourth insulating film 27 interposed.

The gate trench GT extends in, for example, a Y-direction below the second electrode 30. Each of the control electrode 40, the third electrode 50, and the fourth electrode 60, for example, continuously extends in the Y-direction in the gate trench GT.

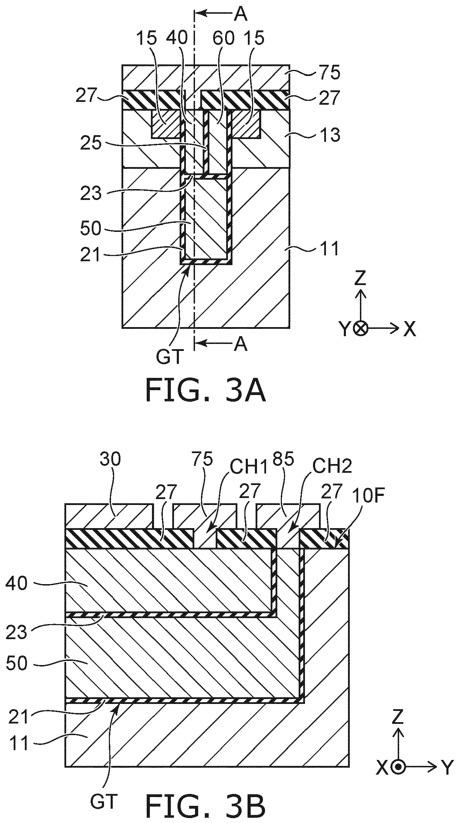

The first control pad 70 is electrically connected to the control electrode 40 via the first interconnect 75 (see FIG. 3B). The second control pad 80 is electrically connected to the third and fourth electrodes 50 and 60 via the second interconnect 85 (see FIG. 4B). The first control pad 70 and the first interconnect 75 are electrically insulated from the second control pad 80 and the second interconnect 85.

FIGS. 3A and 3B are other schematic cross-sectional views showing the semiconductor device 1 according to the embodiment. FIG. 3A is a schematic view showing a cross-section of the gate trench GT at a contact region CA shown in FIG. 2. FIG. 3B is a cross-sectional view along line A-A shown in FIG. 3A.

As shown in FIG. 3A, the first interconnect 75 extends over the fourth insulating film 27 in a direction crossing the gate trenches GT. The first interconnect 75 is connected to the control electrode 40 via a contact hole CH1 provided in the fourth insulating film 27.

As shown in FIG. 3B, the control electrode 40 and the third electrode 50 extend in the Y-direction. The control electrode 40 is connected to the first interconnect 75 at the end portion of the control electrode 40; and the third electrode 50 is connected to the second interconnect 85 at the end portion of the third electrode 50. The third electrode 50 is drawn out to the same level as the front surface 10F of the semiconductor part 10 at the end of the gate trench GT; and the second interconnect 85 is connected to the third electrode 50 via a contact hole CH2 provided in the fourth insulating film 27.

FIGS. 4A and 4B are other schematic views showing a cross-section of the semiconductor device according to the embodiment. FIG. 4A is the same cross-sectional view as the cross-sectional view of the gate trench GT shown in FIG. 3A. FIG. 4B is a cross-sectional view along line B-B shown in FIG. 4A.

As shown in FIG. 4B, the third electrode 50 is drawn out to the same level as the front surface 10F of the semiconductor part 10 at the end of the gate trench GT. The fourth electrode 60 is connected to a draw-out portion 50e of the third electrode 50 at the end of the gate trench GT. The second interconnect 85 is connected to the draw-out portion 50e of the third electrode 50 via the contact hole CH2 provided in the fourth insulating film 27.

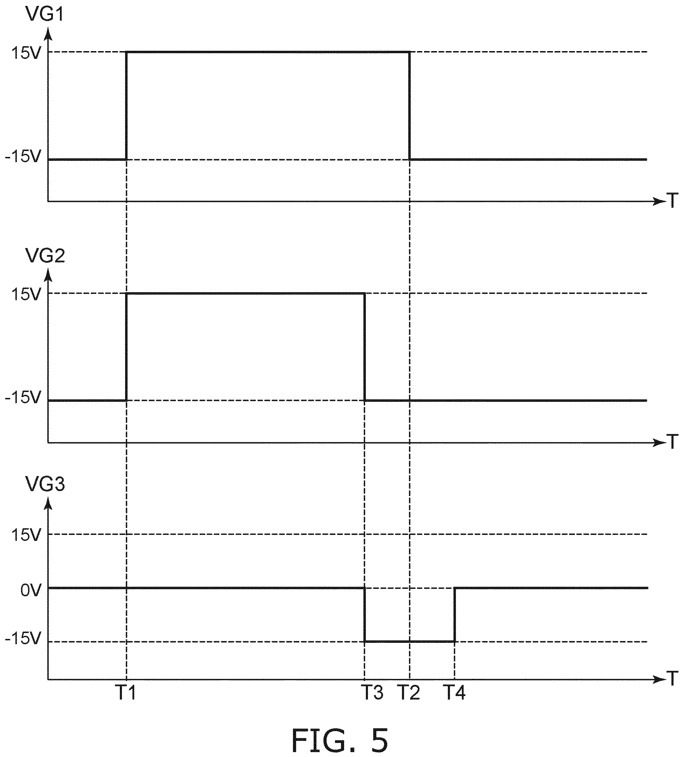

FIG. 5 is a time chart showing operations of the semiconductor device 1 according to the embodiment. The horizontal axis is a time T; and the vertical axis is gate voltages VG1, VG2, and VG3. Two examples of the gate control by the gate voltages VG1 to VG3 shown in FIG. 5 will now be described.

### First control example

The gate voltage VG1 is applied between the second electrode 30 and the first control pad 70. The gate voltage VG2 is applied between the second electrode 30 and the second control pad 80. The gate voltage VG1 is applied to the control electrode 40 via the first control pad 70. The gate voltage VG2 is applied to the third and fourth electrodes 50 and 60 via the second control pad 80. In the example, the gate voltage VG3 is applied to none of the control electrode 40, the third electrode 50, and the fourth electrode 60.

As shown in FIG. 5, at a time T1, the voltages of the control electrode 40, the third electrode 50, and the fourth electrode 60 are increased up to a level greater than the threshold voltage, for example, from -15 V to 15 V. Thereby, an inversion layer of the first conductivity type is induced at the interface between the first insulating film 21 and the second semiconductor layer 13 that faces the control electrode 40 and the fourth electrode 60; and the semiconductor device 1 transitions from the off-state to the on-state (i.e., turn-on). At a time T2 after the time T1, the voltage that is applied to the control electrode 40 is returned to -15 V, which is less than the threshold voltage. At a time T3 that is after the time T1 and directly before the time T2, the voltages of the third and fourth electrodes 50 and 60 are returned to -15 V. Thereby, the inversion layer of the first conductivity type disappears at the interface between the second semiconductor layer 13 and the first insulating film 21.

At the time T2, the semiconductor device 1 transitions from the on-state to the off-state (turns off) at which the inversion layer completely disappears at the interface between the second semiconductor layer 13 and the first insulating film 21. Moreover, at the time T3 directly before the time T2, an inversion layer of the second conductivity type is induced at the interface between the first insulating film 21 and the first semiconductor layer 11 that faces the third electrode 50. Thereby, the holes injected inside the first semiconductor layer 11 during the on-state can be ejected from the first semiconductor layer 11 to the second electrode 30 via the second semiconductor layer 13 before turn-off is started at the time T2; and the turn-off time can be reduced. The switching loss of the turn-off process of the semiconductor device 1 can be reduced thereby.

In the example, the same bias as that applied to the third electrode 50 also is applied to the fourth electrode 60 so that the holes smoothly move to the second semiconductor layer 13 via the inversion layer of the second conductivity type induced at the interface between the first insulating film 21 and the first semiconductor layer 11. Moreover, the ejection resistance of the holes generated by the avalanche phenomenon in the first semiconductor layer 11 facing the bottom portion of the gate trench GT can be reduced thereby, and the avalanche resistance also can be improved.

### Second control example

The semiconductor device 1 may be configured so that the third electrode 50 and the fourth electrode 60 are independently controlled. In other words, the fourth electrode 60 is not connected to the third electrode 50 and is electrically connected to a third control pad (not illustrated) other than the first and second control pads 70 and 80.

The gate voltage VG1 is applied to the control electrode 40 via the first control pad 70. The gate voltage VG2 is applied to the fourth electrode 60 via the third control pad (not illustrated). The gate voltage VG3 is applied to the third electrode 50 via the second control pad 80.

In the example, at the time T1, the voltages of the control electrode 40 and the fourth electrode 60 are increased from -15 V to 15 V. At this time, the voltage of the third electrode 50 is 0 V. Accordingly, the inversion layer of the first conductivity type is induced between the second semiconductor layer 13 and the first insulating film 21; and the semiconductor device 1 transitions from the off-state to the on-state.

According to the first control example, when the control electrode 40 and the fourth electrode 60 are turned on at the time T1, the third electrode 50 has the same potential as the fourth electrode 60. The potential of the third electrode 50 rises from -15 V to 15 V in the turn-on operation. When the third electrode 50 has the negative potential, a second conductivity type inversion layer is induced at the interface between the first semiconductor layer 11 and the first insulating film 21. When the potential of the third electrode 50 rises and becomes a positive potential, a first conductivity type accumulation layer is formed after the p-type inversion layer disappears. In contrast, in the second control example, the voltage of the third electrode 50 is 0 V, and neither a p-type inversion layer nor an n-type accumulation layer is induced. Therefore, the carrier flow that passes through the first semiconductor layer 11 proximate to the first insulating film 21 can be stabilized, and the turn-on characteristics can be stabilized.

Then, the gate voltage VG1 is reduced from 15 V to -15 V at the time T2; and the turn-off process is started thereby. At the time T3 directly before the time T2, the gate voltage VG2 is reduced from 15 V to -15 V, and the gate voltage VG3 is reduced from 0 V to -15 V. Thereby, a second conductivity type inversion layer is induced at the interface between the first semiconductor layer 11 and the first insulating film 21, and the hole ejection is promoted. Thereby, it is possible in the semiconductor device 1 to reduce the switching loss of the turn-off process.

According to the embodiment, at the bottom portions of the multiple gate trenches GT, uniform electric field is provided by providing the third electrodes 50 respectively in the bottom portions of the gate trenches GT. Thus, it is possible to avoid element breakdown by the locally concentrated avalanche current due to nonuniformity of the electric field between the bottom portions of the trench gates GT.

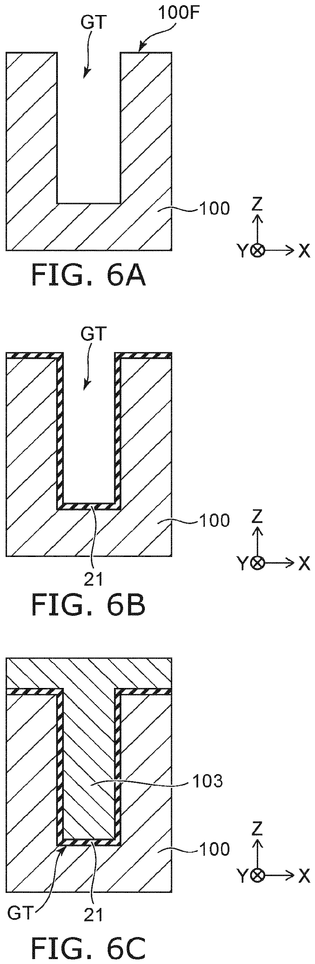

A method for manufacturing the semiconductor device 1 will now be described with reference to FIGS. 6A to 8C. FIGS. 6A to 8C are schematic cross-sectional views showing manufacturing processes of the semiconductor device 1 according to the embodiment.

FIGS. 6A to 8C show a method of forming the control electrode 40, the third electrode 50, and the fourth electrode 60 in the gate trench GT.

As shown in FIG. 6A, the gate trench GT is formed in a front surface 100F side of a semiconductor wafer 100. The semiconductor wafer 100 is, for example, n-type silicon. The gate trench GT is formed by selectively removing the semiconductor wafer 100 using an etching mask (not illustrated). The semiconductor wafer 100 is removed using anisotropic RIE (Reactive Ion Etching).

As shown in FIG. 6B, the first insulating film 21 is formed at the front surface 100F side of a semiconductor wafer 100. The first insulating film 21 covers the inner surface of the gate trench GT with a space that remains in the gate trench GT. The first insulating film 21 is, for example, a silicon oxide film. The first insulating film 21 is formed by thermal oxidation of the semiconductor wafer 100.

As shown in FIG. 6C, a conductive film 103 is formed on the first insulating film 21. The space in the gate trench GT is filled with the conductive film 103. The conductive film 103 is, for example, a conductive polysilicon film. The conductive film 103 is formed using, for example, CVD (Chemical Vapor Deposition).

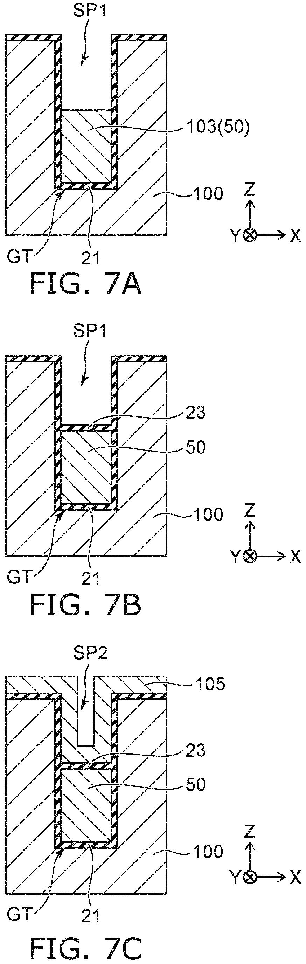

As shown in FIG. 7A, the conductive film 103 is removed so that the portion thereof remains at the bottom of the gate trench GT. A first space SP1 is formed at the upper portion of the gate trench GT. The conductive film 103 is removed using, for example, isotropic dry etching. The portion of the conductive film 103 that remains at the bottom of the gate trench GT becomes the third electrode 50.

As shown in FIG. 7B, in the first space SP1, the second insulating film 23 is formed on the third electrode 50. The second insulating film 23 is, for example, a silicon oxide film. The second insulating film 23 is formed by, for example, thermal oxidation of the third electrode 50.

As shown in FIG. 7C, a conductive film 105 is formed on the semiconductor wafer 100. The conductive film 105 covers the inner surface of the first space SP1. The conductive film 105 is formed so that a second space SP2 remains inside the gate trench GT. The conductive film 105 is, for example, a conductive polysilicon film. The conductive film 105 is formed using, for example, CVD.

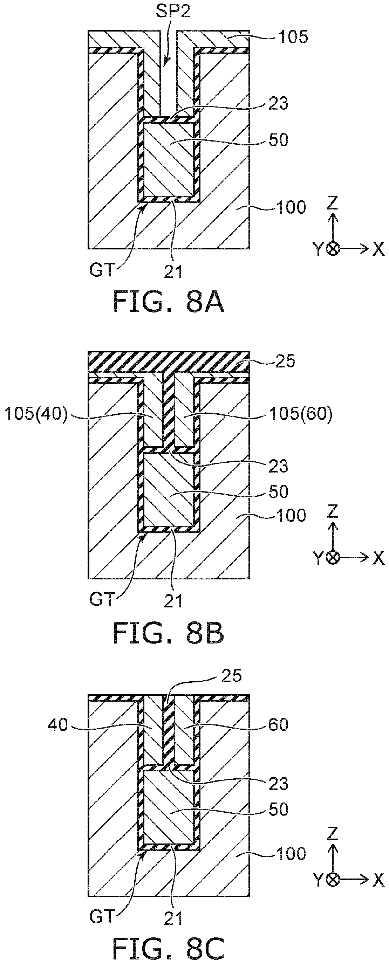

As shown in FIG. 8A, the conductive film 105 formed on the second insulating film 23 is partially removed so that the portion of the conductive film 105 remains on the inner wall of the gate trench GT. The conductive film 105 is removed via the second space SP2 using, for example, anisotropic RIE.

As shown in FIG. 8B, the third insulating film 25 is formed on the semiconductor wafer 100. The second space SP2 is filled with the third insulating film 25. The third insulating film 25 is, for example, a silicon oxide film. The third insulating film 25 is formed using, for example, CVD.

As shown in FIG. 8C, the third insulating film 25 and the conductive film 105 are removed so that the portion of the conductive film 105 remains inside the gate trench GT. The third insulating film 25 and the conductive film 105 are removed using, for example, isotropic dry etching or CMP (Chemical Mechanical Polishing). The portion of the conductive film 105 that remains inside the gate trench GT becomes the control electrode 40 and the fourth electrode 60.

The manufacturing method described above is an example; and the embodiments are not limited thereto. For example, in the process shown in FIG. 7C, the first space SP1 inside the gate trench GT may be filled with the conductive film 105. Subsequently, the second space SP2 may be formed by selective etching the conductive film 105 using an etching mask.

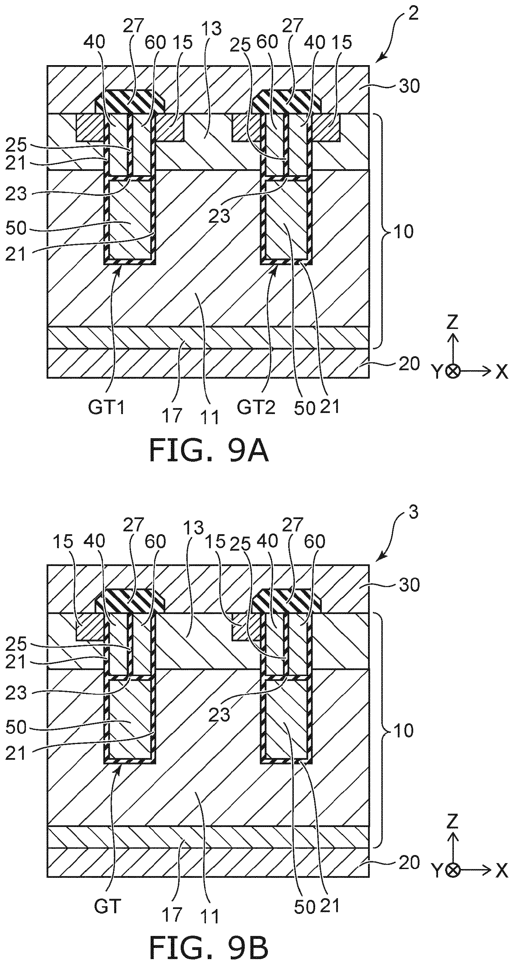

FIGS. 9A and 9B are schematic cross-sectional views showing semiconductor devices 2 and 3 according to a first modification of the embodiment.

As shown in FIG. 9A, the semiconductor device 2 includes the gate trenches GT1 and GT2 adjacent to each other; and a fourth electrodes 60 in the gate trench GT1 faces another fourth electrodes 60 in the gate trench GT2 via the second semiconductor layer 13. Also, two control electrodes 40 may be configured to face each other via another second semiconductor layer 13. Thus, the positional relationship of the control electrode 40 and the fourth electrode 60 in an X-direction can be selected as appropriate.

As shown in FIG. 9B, in the semiconductor device 3, the third semiconductor layer 15 faces the control electrode 40 via the first insulating film 21; and the other third semiconductor layer 15 facing the fourth electrode 60 via the first insulating film (see FIG. 1) is not provided in this case.

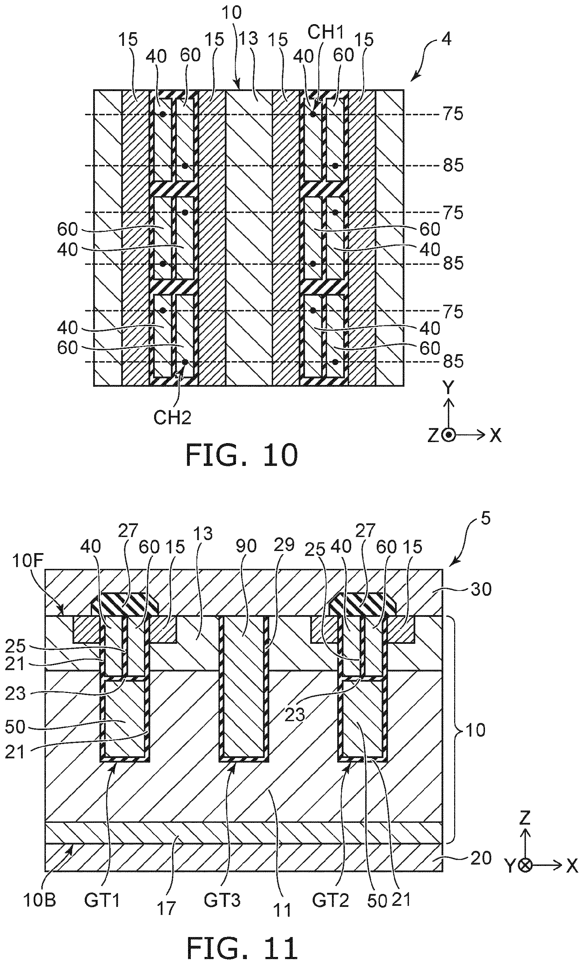

FIG. 10 is a schematic plan view showing a semiconductor device 4 according to a second modification of the embodiment. FIG. 10 is a plan view showing the front surface 10F side of the semiconductor part 10. The second electrode 30 is not illustrated in FIG. 10.

As shown in FIG. 10, multiple control electrodes 40 and multiple fourth electrodes 60 may be provided in one gate trench GT. In the gate trench GT, the control electrodes 40 and the fourth electrodes 60 are provided on the third electrode 50 and alternately arranged in the Y-direction. In the X-direction, the control electrode 40 faces the fourth electrode 60. The embodiment is not limited to the example, and there may be a case where the fourth electrodes 60 face each other and the control electrodes 40 face each other with the second semiconductor layer 13 interposed. The third electrode 50 continuously extends in the Y-direction at the lower portion of the gate trench GT.

The first interconnect 75 extends in the X-direction and is connected to the control electrode 40 via the contact hole CH1. The second interconnect 85 also extends in the X-direction and is connected to the fourth electrode 60 via the contact hole CH2. In such a case, the first interconnect 75 and the second interconnect 85 are interlayer interconnects provided between the semiconductor part 10 and the second electrode 30.

FIG. 11 is a schematic cross-sectional view showing a semiconductor device 5 according to a third modification of the embodiment. In the semiconductor device 5, a third gate trench GT3 is further provided between the adjacent gate trench GT1 and gate trench GT2.

The semiconductor device 5 further includes a fifth electrode 90 provided inside the gate trench GT3. Inside each of the gate trenches GT1 and GT2, the control electrode 40, the third electrode 50, and the fourth electrode 60 are provided.

The gate trench GT3 extends into the first semiconductor layer 11 from the front surface 10F side of the semiconductor part 10. The fifth electrode 90 faces the first semiconductor layer 11 via a fifth insulating film 29. The fifth electrode 90 also faces the second semiconductor layer 13 via the fifth insulating film 29. The fifth electrode 90 is isolated from the semiconductor part by the fifth insulating film 29. The fifth electrode 90 is, for example, conductive polysilicon. The fifth electrode 90 may be electrically connected to the second electrode 30 or may be controlled independently from the other electrodes.

The manufacturing method according to the embodiment is not limited to the example. In the semiconductor device 5, at least one gate trench GT3 is provided between the gate trench GT1 and the gate trench GT2.

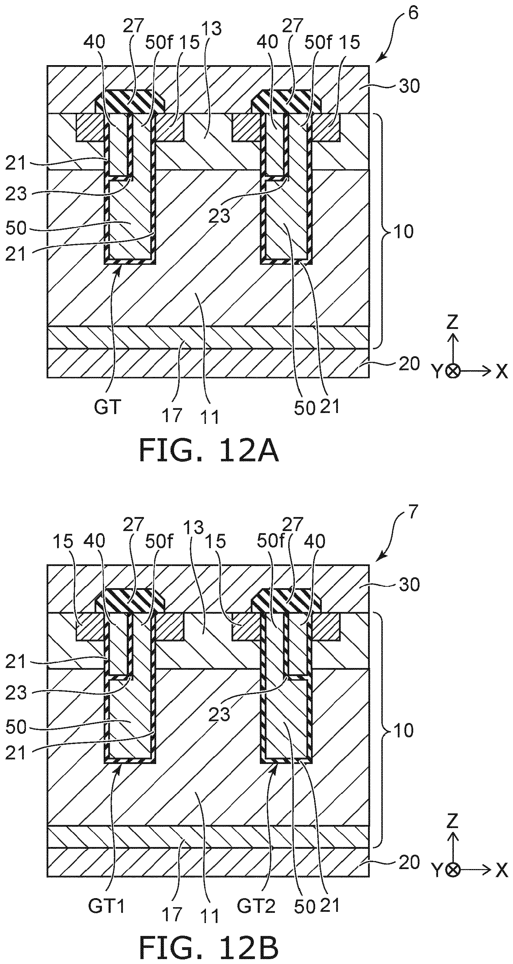

FIGS. 12A and 12B are schematic cross-sectional views showing semiconductor devices 6 and 7 according to a fourth modification of the embodiment. As shown in FIGS. 12A and 12B, the semiconductor devices 6 and 7 is provided without the fourth electrode 60.

As shown in FIG. 12A, the gate trench GT includes the control electrode 40 and the third electrode 50. The control electrode 40 is provided between the second electrode 30 and the third electrode 50. The third electrode 50 includes an extension portion 50f extending between the control electrode 40 and the second semiconductor layer 13. The control electrode 40 and the extension portion 50f of the third electrode 50 are arranged, for example, in the X-direction.

The control electrode 40 faces the third electrode 50 via the second insulating film 23 and is electrically insulated from the third electrode 50 by the second insulating film 23. The control electrode 40 and the third electrode 50 are electrically insulated from the semiconductor part 10 by the first insulating film 21. The extension portion 50f of the third electrode 50 faces the second semiconductor layer 13 via the first insulating film 21.

As shown in FIG. 12B, two third electrodes 50 provided respectively in two adjacent gate trenches GT1 and GT2 may include the extension portions 50f facing each other via the second semiconductor layer 13. The control electrode 40 in the gate trench GT1 or GT2 may face other control electrode 40 in other gate trench via other second semiconductor layer 13.

In the semiconductor devices 6 and 7, an inversion layer of the second conductivity type also can be induced at the interface between the first insulating film 21 and the first semiconductor layer 11 facing the third electrode 50; and the hole ejection from the first semiconductor layer 11 to the second electrode 30 is promoted. Also, due to the extension portion 50f of the third electrode 50 extending between the control electrode 40 and the second semiconductor layer 13, the inversion layer of the second conductivity type is linked to the second semiconductor layer 13, and the holes are smoothly ejected thereto. The avalanche resistance can be further improved thereby. The semiconductor devices 6 and 7 may be configured to further include the fifth electrode 90 (see FIG. 11).

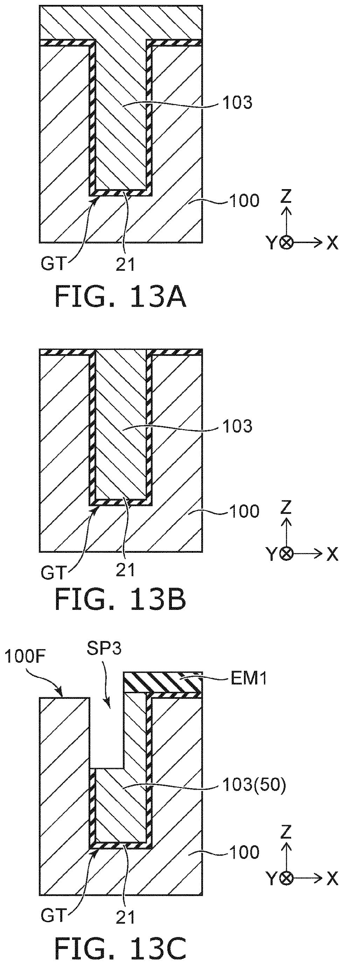

FIGS. 13A to 14C are schematic cross-sectional views showing manufacturing processes of the semiconductor device 6 according to the fourth modification of the embodiment. FIGS. 13A to 14C show a method of forming the control electrode 40 and the third electrode 50 in the gate trench GT.

As shown in FIG. 13A, the conductive film 103 is formed on the first insulating film 21. The gate trench GT is filled with the conductive film 103 (see FIGS. 6A to 6C).

As shown in FIG. 13B, the conductive film 103 is removed so that the portion thereof remains inside the gate trench GT. The conductive film 103 is removed using, for example, isotropic dry etching or CMP.

As shown in FIG. 13C, an etching mask EM1 is formed at the front surface 100F side of the semiconductor wafer 100; and the conductive film 103 in the gate trench GT is partially removed. Thereby, a third space SP3 is formed inside the gate trench GT so that the remaining portion thereof becomes the third electrode 50. The first insulating film 21 may be partially removed through this process.

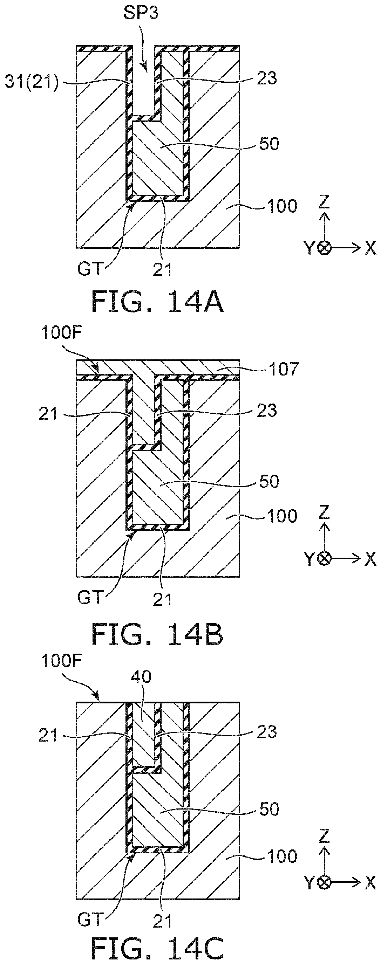

As shown in FIG. 14A, the second insulating film 23 is formed by thermal oxidation of the third electrode 50. Also, a sixth insulating film 31 is formed by thermal oxidation of the exposed portion in the semiconductor wafer 100. The sixth insulating film 31 is, for example, a silicon oxide film and is linked to the first insulating film 21 as a continuous body. The second insulating film 23 and the sixth insulating film 31 are formed so that the third space SP3 remains in the gate trench GT.

As shown in FIG. 14B, a conductive film 107 is formed on the front surface 100F of the semiconductor wafer 100. The conductive film 107 is, for example, a conductive polysilicon film formed by CVD. The third space SP3 is filled with the conductive film 107.

As shown in FIG. 14C, the conductive film 107 is partially removed on the front surface of the semiconductor wafer 100 and above the gate trench GT so that the portion thereof remains in the gate trench GT. Thereby, the control electrode 40 is formed inside the third space SP3 (see FIG. 14A). The conductive film 107 is removed using, for example, isotropic dry etching or CMP. At this time, the first insulating film 21 and the second insulating film 23 also are partially removed, and the upper surfaces of the front surface 100F of the semiconductor wafer 100, the control electrode 40, and the third electrode 50 are exposed.

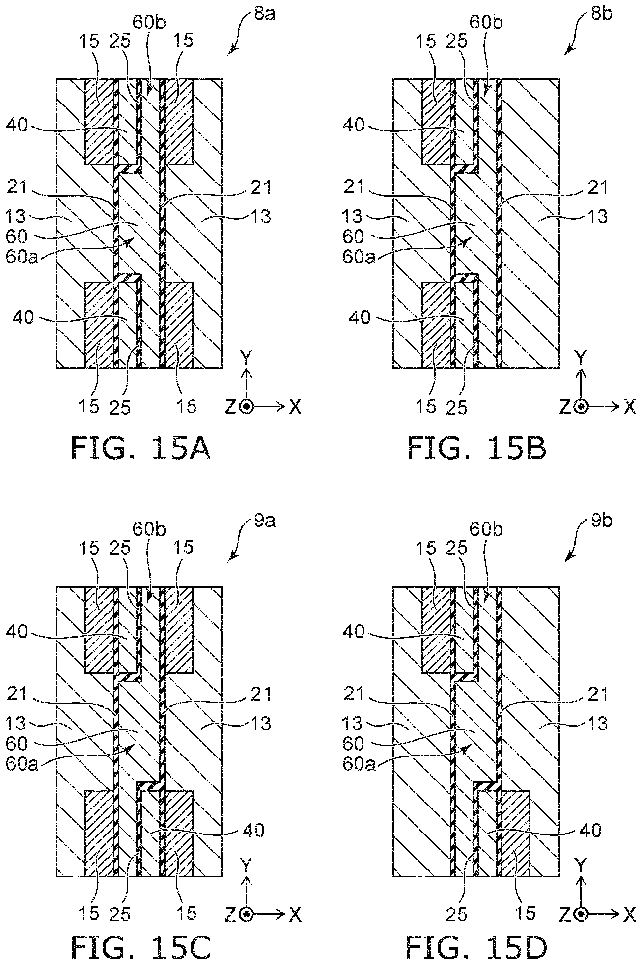

FIGS. 15A to 15D are schematic cross-sectional views showing semiconductor devices 8a, 8b, 9a and 9b according to a fifth modification of the embodiment. FIGS. 15A to 15D are plan views showing the front surface 10F side of the semiconductor part 10.

The semiconductor devices 8a, 8b, 9a and 9b each include multiple control electrodes 40 and a fourth electrode 60. The fourth electrode 60 includes, for example, a first portion 60a and a second portion 60b. The fourth electrode 60 may be replaced by the third electrode 50. The first portion 60a and second portion 60b shown in FIGS. 15A to 15D may be an extension portion of the third electrode 50 (see the third electrode 50 in FIGS. 12A and 12B).

In the example shown in FIGS. 15A and 15B, the multiple control electrodes 40 are apart from each other in the Y-direction. The first portion 60a is positioned between two adjacent control electrodes 40 in the Y-direction. The second portion 60b of the fourth electrode 60 extends, for example, in the Y-direction; and the control electrode 40 and the second portion 60b are arranged in the X-direction. In the plan view, the second portion 60b extends from the first portion 60a in the Y-direction or the opposite direction. The first portion 60a faces the second semiconductor layer 13 via the first insulating film 21 at the front surface 10F side of the semiconductor part 10.

As shown in FIG. 15A, in the semiconductor device 8a, the third semiconductor layer 15 faces the control electrode 40 via the first insulating film 21. Another third semiconductor layer 15 faces the second portion 60b of the fourth electrode 60 via the first insulating film 21. The third semiconductor layer 15 and the other third semiconductor layer 15 are arranged in the X-direction; and the control electrode 40 and the second portion 60b of the fourth electrode 60 are arranged between the third semiconductor layer 15 and the other third semiconductor layer 15. The third semiconductor layer 15 is provided without facing the first portion 60a of the fourth electrode 60.

As shown in FIG. 15B, in the semiconductor device 8b, the third semiconductor layer 15 faces the control electrode 40 via the first insulating film 21, and is provided without facing the fourth electrode 60 via the first insulating film 21.

As shown in FIGS. 15C and 15D, the control electrode 40 and the second portion 60b of the fourth electrode 60 are arranged in the Y-direction with the first portion 60a of the fourth electrode 60 interposed. Also, the control electrode 40 and the second portion 60b of the fourth electrode 60 are arranged in the X-direction. The second portion 60b extends from the first portion 60a in the Y-direction or the opposite direction. The first portion 60a faces the second semiconductor layer 13 via the first insulating film 21 at the front surface 10F of the semiconductor part 10.

As shown in FIG. 15C, in the semiconductor device 9a, the third semiconductor layer 15 faces the control electrode 40 via the first insulating film 21. Also, another third semiconductor layer 15 faces the second portion 60b of the fourth electrode 60 via the first insulating film 21. The third semiconductor layer 15 and the other third semiconductor layer 15 are arranged in the X-direction; and the control electrode 40 and the second portion 60b of the fourth electrode 60 are arranged between the third semiconductor layer 15 and the other third semiconductor layer 15. The third semiconductor layer 15 is provided without facing the first portion 60a of the fourth electrode 60.

As shown in FIG. 15D, in a semiconductor device 9b, the third semiconductor layer 15 faces the control electrode 40 via the first insulating film 21, and is provided without facing the fourth electrode 60 via the first insulating film 21.

According to the embodiments, the semiconductor device includes the following aspects:
Note 1: A semiconductor device, comprising:
   a semiconductor part;
   a first electrode provided on a back surface of the semiconductor part;
   a second electrode provided on a front surface of the semiconductor part at a side opposite to the back surface;
   a third electrode provided between the first electrode and the second electrode, the third electrode being provided in the semiconductor part with a first insulating film interposed and being electrically insulated from the semiconductor part by the first insulating film; and
   a control electrode provided between the second electrode and the third electrode, the control electrode extending into the semiconductor part from the front side of the semiconductor part and facing the third electrode with a second insulating film interposed, the first insulating film extending between the semiconductor part and the control electrode and electrically insulating the control electrode from the semiconductor part,
   the third electrode including an extension portion extending between the semiconductor part and the control electrode, the first insulating film extending between the semiconductor part and the extension portion, the control electrode facing the extension portion via the second insulating film.
Note 2: The device according to note 1, wherein the second electrode is provided on the control electrode and the extension portion of the third electrode with a fourth insulating film interposed; and the control electrode and the extending portion of the third electrode are electrically insulated from the second electrode by the fourth insulating film.
Note 3: The device according to note 1 or 2, wherein the semiconductor part includes first to fourth semiconductor layers,
   the first semiconductor layer being of a first conductivity type and extending between the first electrode and the second electrode, the third electrode facing the first semiconductor layer via the first insulating film,
   the second semiconductor layer being of a second conductivity type and provided between the first semiconductor layer and the second electrode, the second semiconductor layer facing the control electrode with the first insulating film interposed,
   the third semiconductor layer being of the first conductivity type and partially provided on the second semiconductor layer, the third semiconductor layer contacting the first insulating film between the second semiconductor layer and the second electrode,
   the fourth semiconductor layer being of the second conductivity type and provided between the first semiconductor layer and the first electrode.
Note 4: The device according to note 3, wherein the third semiconductor layer faces the control electrode with the first insulating film interposed.
Note 5: The device according to note 3 or 4, further comprising a fifth electrode provided between the first electrode and the second electrode, wherein the fifth electrode extends into the first semiconductor layer from the front side of the semiconductor part with a fifth insulating film interposed, the fifth electrode being isolated from the semiconductor part by the fifth insulating film; and the second and third semiconductor layers are provided between the control electrode and the fifth electrode.
Note 6: The device according to note 5, wherein the fifth electrode is electrically connected to the second electrode.
Note 7: The device according to any one of notes 1 to 6, further comprising a first control pad and a second control pad, wherein the first control pad is provided at the front side of the semiconductor part, the first control pad being apart from the second electrode and electrically connected to the control electrode via a first interconnect; and the second control pad is provided at the front side of the semiconductor part, the second control pad being apart from the second electrode and the first control pad and electrically connected to the third electrode via a second interconnect.
Note 8: The device according to any one of notes 1 to 7, further comprising a second third-electrode and a second control electrode, wherein
   the second third-electrode is provided between the first electrode and the second electrode, the second third-electrode being provided in the semiconductor part with a second first-insulating film interposed and being electrically insulated from the semiconductor part by the second first-insulating film;
   the second control electrode is provided between the second electrode and the second third-electrode, the second control electrode extending into the semiconductor part from the front side of the semiconductor part and facing the second third-electrode with a second second-insulating film interposed, the second first-insulating film extending between the semiconductor part and the second control electrode and electrically insulating the second control electrode from the semiconductor part;
   the second third-electrode includes a second extension portion extending between the semiconductor part and the second control electrode, the second first-insulating film extending between the semiconductor part and the second extension portion, the second control electrode facing the second extension portion via the second second-insulating film; and
   the second extension portion of the second third-electrode faces the extension portion of the third electrode via the semiconductor part.
Note 9: The device according to any one of notes 1 to 7, further comprising a second third-electrode and a second control electrode, wherein
   the second third-electrode is provided between the first electrode and the second electrode, the second third-electrode being provided in the semiconductor part with a second first-insulating film interposed and being electrically insulated from the semiconductor part by the second first-insulating film;
   the second control electrode is provided between the second electrode and the second third-electrode, the second control electrode extending into the semiconductor part from the front side of the semiconductor part and facing the second third-electrode with a second second-insulating film interposed, the second first-insulating film extending between the semiconductor part and the second control electrode and electrically insulating the second control electrode from the semiconductor part;
   the second third-electrode includes a second extension portion extending between the semiconductor part and the second control electrode, the second first-insulating film extending between the semiconductor part and the second extension portion, the second control electrode facing the second extension portion via the second second-insulating film; and
   the second control electrode faces the control electrode via the semiconductor part.
Note 10: The device according to any one of notes 1 to 9, wherein the extension portion of the third electrode includes a first extension portion and a second extension portion, the second extension portion extending from the first extension portion in a plan view parallel to the front surface of the semiconductor part; and the second extension portion and the control electrode are arranged in a direction crossing the extension direction of the second extension portion.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and overview of the invention.

It is explicitly stated that all features disclosed in the description and/or the claims are intended to be disclosed separately and independently from each other for the purpose of original disclosure as well as for the purpose of restricting the claimed invention independent of the composition of the features in the embodiments and/or the claims. It is explicitly stated that all value ranges or indications of groups of entities disclose every possible intermediate value or intermediate entity for the purpose of original disclosure as well as for the purpose of restricting the claimed invention, in particular as limits of value ranges.

## Claims

1. A semiconductor device (1 to 5, 8a, 8b, 9a, 9b), comprising:
a semiconductor part (10);
a first electrode (20) provided on a back surface (10B) of the semiconductor part (10);
a second electrode (30) provided on a front surface (10F) of the semiconductor part (10) at a side opposite to the back surface (10B);
a third electrode (50) provided between the first electrode (20) and the second electrode (30), the third electrode (50) being provided in the semiconductor part (10) with a first insulating film (21) interposed, the third electrode (50) being electrically insulated from the semiconductor part (10) by the first insulating film (21);
a control electrode (40) provided between the second electrode (30) and the third electrode (50), the control electrode (40) extending into the semiconductor part (10) from the front side (10F) of the semiconductor part (10) and facing the third electrode (50) with a second insulating film (23) interposed, the first insulating film (21) extending between the semiconductor part (10) and the control electrode (40) and electrically insulating the control electrode (40) from the semiconductor part (10); and
a fourth electrode (60) provided between the second electrode (30) and the third electrode (50), the fourth electrode (60) extending into the semiconductor part (10) from the front side (10F) of the semiconductor part (10) and being positioned between the semiconductor part (10) and the control electrode (40), the first insulating film (21) extending between the semiconductor part (10) and the fourth electrode (60), the second insulating film (23) extending between the third electrode (50) and the fourth electrode (60), the fourth electrode (60) facing the control electrode (40) with a third insulating film (25) interposed, the fourth electrode (60) being electrically connected to the third electrode (50).

2. The device (1 to 5, 8a, 8b, 9a, 9b) according to claim 1, wherein
the second electrode (30) is provided on the control electrode (40) and the fourth electrode (60) with a fourth insulating film (27) interposed, and
the control electrode (40) and the fourth electrode (60) is electrically insulated from the second electrode (30) by the fourth insulating film (27).

3. The device (1 to 5, 8a, 8b, 9a, 9b) according to claim 1 or 2, wherein
the semiconductor part (10) includes first to fourth semiconductor layers (11, 13, 15, 17),
the first semiconductor layer (11) being of a first conductivity type and extending between the first electrode (20) and the second electrode (30), the third electrode (50) facing the first semiconductor layer (11) via the first insulating film (21),
the second semiconductor layer (13) being of a second conductivity type and provided between the first semiconductor layer (11) and the second electrode (30), the second semiconductor layer (13) facing the control electrode (40) with the first insulating film (21) interposed,
the third semiconductor layer (15) being of the first conductivity type and partially provided on the second semiconductor layer (13), the third semiconductor layer (15) contacting the first insulating film (21) between the second semiconductor layer (13) and the second electrode (30),
the fourth semiconductor layer (17) being of the second conductivity type and provided between the first semiconductor layer (11) and the first electrode (20).

4. The device (1 to 5, 8a, 8b, 9a, 9b) according to claim 3, wherein the third semiconductor layer (15) faces the control electrode (40) with the first insulating film (21) interposed.

5. The device (3, 8b, 9b) according to claim 4, wherein the third semiconductor layer (15) is provided on the second semiconductor layer (13) without facing the fourth electrode (60).

6. The device (4) according to any one of claims 1 to 4, wherein a plurality of the control electrodes 40 and a plurality of the fourth electrodes are provided on the third electrode (50) and alternately arranged along the front side (10F) of the semiconductor part 10.

7. The device (5) according to claim 3 or 4, further comprising:
a fifth electrode (90) provided between the first electrode (20) and the second electrode (30), the fifth electrode (90) extending into the first semiconductor layer (11) from the front side (10F) of the semiconductor part (10) with a fifth insulating film (29) interposed, the fifth electrode (90) being isolated from the semiconductor part (10) by the fifth insulating film (29),
the second and third semiconductor layers (13, 15) being provided between the control electrode (40) and the fifth electrode (90).

8. The device (5) according to claim 7, wherein the fifth electrode (90) is electrically connected to the second electrode (30).

9. The device (1 to 5, 8a, 8b, 9a, 9b) according to any one of claims 1 to 8, further comprising:
a first control pad (70) provided at the front side (10F) of the semiconductor part (10), the first control pad (70) being apart from the second electrode (30) and electrically connected to the control electrode (40) via a first interconnect (75); and
a second control pad (80) provided at the front side (10F) of the semiconductor part (10), the second control pad (80) being apart from the second electrode (30) and the first control pad (70) and electrically connected to the third electrode (50) via a second interconnect (85).

10. The device (2) according to any one of claims 1 to 4, 9, further comprising:
a second third-electrode (50) provided between the first electrode (20) and the second electrode (30), the second third-electrode (50) being provided in the semiconductor part (10) with a second first-insulating film (21) interposed and being electrically insulated from the semiconductor part (10) by the second first-insulating film (21);
a second control electrode (40) provided between the second electrode (30) and the second third-electrode (50), the second control electrode (40) extending into the semiconductor part (10) from the front side (10F) of the semiconductor part (10) and facing the second third-electrode (50) with a second second-insulating film (23) interposed, the second first-insulating film (21) extending between the semiconductor part (10) and the second control electrode (40) and electrically insulating the second control electrode (40) from the semiconductor part (10); and
a second fourth-electrode (60) provided between the second electrode (30) and the second third-electrode (50), the second fourth-electrode (60) extending into the semiconductor part (10) from the front side (10F) of the semiconductor part (10) and being positioned between the semiconductor part (10) and the second control electrode (40), the second first-insulating film (21) extending between the semiconductor part (10) and the second fourth-electrode (60), the second second-insulating film (23) extending between the second third-electrode (50) and the second fourth-electrode (60), the second fourth-electrode (60) facing the second control electrode (40) with a second thirdinsulating film (25) interposed and being electrically connected to the second third-electrode (50),
the second fourth-electrode (60) facing the fourth electrode (60) via the semiconductor part (10).

11. The device (2) according to any one of claims 1 to 4, 9, further comprising:
a second third-electrode (50) provided between the first electrode (20) and the second electrode (30), the second third-electrode (50) being provided in the semiconductor part (10) with a second first-insulating film (21) interposed and being electrically insulated from the semiconductor part (10) by the second first-insulating film (21);
a second control electrode (40) provided between the second electrode (30) and the second third-electrode (50), the second control electrode (40) extending into the semiconductor part (10) from the front side (10F) of the semiconductor part (10) and facing the second third-electrode (50) with a second second-insulating film (23) interposed, the second first-insulating film (21) extending between the semiconductor part (10) and the second control electrode (40) and electrically insulating the second control electrode (40) from the semiconductor part (10); and
a second fourth-electrode (60) provided between the second electrode (30) and the second third-electrode (50), the second fourth-electrode (60) extending into the semiconductor part (10) from the front side (10F) of the semiconductor part (10) and being positioned between the semiconductor part (10) and the second control electrode (40), the second first-insulating film (21) extending between the semiconductor part (10) and the second fourth-electrode (60), the second second-insulating film (23) extending between the second third-electrode (50) and the second fourth-electrode (60), the second fourth-electrode (60) facing the second control electrode (40) with a second thirdinsulating film (25) interposed and being electrically connected to the second third-electrode (50),
the second control electrode (40) facing the control electrode (40) via the semiconductor part (10).

12. The device (8a, 8b, 9a, 9b) according to anyone of claims 1 to 11, wherein
the fourth electrode (60) includes a first portion (60a) and a second portion (60b), the second portion (60b) extending from the first portion (60a) in a plan view parallel to the front surface (10F) of the semiconductor part (10), and
the second portion (60b) of the fourth electrode (60) and the control electrode (40) are arranged in a direction (X) crossing an extension direction (Y) of the second portion (60b).
